Europäisches Patentamt

European Patent Office

Office européen des brevets

(19)

(11) Numéro de publication : **0 493 166 A1**

# (12) DEMANDE DE BREVET EUROPEEN

(21) Numéro de dépôt : **91403345.1**

(22) Date de dépôt : **10.12.91**

(51) Int. Cl.$^5$ : **H01L 21/28, H01L 21/338, H01L 29/812**

(30) Priorité : **14.12.90 FR 9015683**

(43) Date de publication de la demande :
**01.07.92 Bulletin 92/27**

(84) Etats contractants désignés :
**DE GB NL**

(71) Demandeur : **THOMSON COMPOSANTS MICROONDES**
**51, Esplanade du Général de Gaulle**
**F-92800 Puteaux (FR)**

(72) Inventeur : **Debrie, Francis**
**THOMSON-CSF, SCPI, Cédex 67**
**F-92045 Paris la Défense (FR)**
Inventeur : **Garnier, Christophe**
**THOMSON-CSF, SCPI, Cédex 67**
**F-92045 Paris la Défense (FR)**
Inventeur : **Diaz, Jacques**
**THOMSON-CSF, SCPI, Cédex 67**
**F-92045 Paris la Défense (FR)**
Inventeur : **Grisollet, Anne-Marie**
**THOMSON-CSF, SCPI, Cédex 67**
**F-92045 Paris la Défense (FR)**
Inventeur : **Schwob, Véronique**
**THOMSON-CSF, SCPI, Cédex 67**
**F-92045 Paris la Défense (FR)**

(74) Mandataire : **Taboureau, James et al**
**THOMSON-CSF SCPI**
**F-92045 Paris La Défense Cédex 67 (FR)**

(54) **Procédé de réalisation de grilles submicroniques sur un dispositif semiconducteur.**

(57)    L'invention concerne un transistor hyperfréquences, dont au moins une grille doit avoir une longueur inférieure à 1 micron.

Au moyen de matériel de masquage conventionnel, un motif (3 + 4) en relief est réalisé par gravure dans une couche de diélectrique (3) et une couche de métal (4). Une couche (5) de métal, d'épaisseur inférieure à 1 micron, est déposée puis gravée de façon que seule demeure la couche sur les flancs du motif (3 + 4 + 5). Par gravure de ce motif, on forme au moins une grille dont la longueur est submicronique. Selon le type de gravure, on réalise un transistor en anneau, ou bi-grille, ou cascode ou interdigité.

Application aux transistors et circuits intégrés.

FIG.6

La présente invention concerne un procédé de réalisation des grilles hyperfines des transistors. Ce procédé est applicable tant aux transistors en silicium qu'à ceux en GaAs ou autres matériaux du groupe III-V. Il aboutit à des composants ayant normalement un nombre pair d'éléments de grilles hyperfines.

Le procédé selon l'invention apporte une solution unique à plusieurs difficultés bien connues pour réaliser des transistors performants.

Pour répondre aux besoins exprimés, par exemple pour les communications, qui se traduisent par une augmentation incessante des fréquences utilisées, il faut pouvoir réaliser des grilles submicroniques sur les transistors. Lorsque les dimensions ne permettent plus l'utilisation de machines de photolithographie, les moyens à mettre en oeuvre - masquage électronique, rayons X, cyclotron - sont certes très performants, mais très coûteux et très encombrants. En outre, du point de vue fabrication industrielle, ils ne sont pas compétitifs en cadence avec les masqueurs optiques.

L'utilisation des transistors à des fréquences élevées avec des grilles de longueur submicronique s'accompagne d'une augmentation de la résistance linéïque de la grille. On conçoit facilement qu'une métallisation de grille, dont la section fait environ 0,8 x 0,3 micromètres, est un conducteur très résistif : la solution connue consiste à élargir et épaissir la métallisation de grille, à distance de son contact avec la surface de matériau semiconducteur, pour faire une grille en T ou "champignon", à faible résistance électrique.

Enfin, les transistors fonctionnant à fréquences élevées et avec une ou plusieurs grilles submicroniques ont, de façon générale, une faible puissance, en fonction des lois de la physique du solide. Pour augmenter leur puissance, on peut augmenter la tension entre les deux électrodes d'accès, source et drain, ce qui se traduit par une augmentation des tensions de claquage côté drain, et par une augmentation de la résistance d'accès côté source. Il est donc habituel d'éloigner la grille du drain, ce qui permet d'augmenter la tension de claquage grille - drain et de diminuer la résistance d'accès grille - source.

Mais la réalisation de motifs submicroniques est déjà aux limites des moyens industriels de masquage optique. La nécessité de décaler ces motifs, d'avoir des masques dissymétriques, rend l'opération encore plus délicate, et fait chuter les rendements de fabrication pour cause de mauvais alignement entre les niveaux successifs de masquage.

Le procédé selon l'invention permet de réaliser facilement, avec des masques symétriques, des structures dissymétriques, dans lesquelles les grilles sont fines, submicroniques, et décalées vers la source du transistor. Ce procédé repose sur l'utilisation, en surface de la puce du transistor, d'un motif de diélectrique, dont les flancs sont recouverts par une fine couche métallique, et dont la surface libre est recouverte par une épaisse couche métallique. Par gravure, la partie centrale de ce motif de diélectrique et la couche épaisse qui la recouvre sont supprimées, et il reste au moins deux bords, qui forment une grille en "L" inversé - la moitié dune grille en "T", - qui s'appuie sur le diélectrique, et dont l'emplacement du pied de grille est dissymétrique entre source et drain.

De façon plus précise, l'invention concerne un procédé de réalisation de grilles submicroniques sur un dispositif semiconducteur comportant au moins une couche active supportée par un substrat, ce procédé étant caractérisé en ce qu'il comporte les opérations suivantes :

- sur la couche active, déposer une couche épaisse de matériau diélectrique, puis une couche épaisse de métal,
- par masquage et gravure, former dans ces couches au moins un motif polygonal, dont au moins un premier et un second côtés correspondent à la position d'au moins deux futures grilles,
- par un procédé isotrope, déposer une couche de métal d'épaisseur submicronique, puis la graver par un procédé anisotrope, de telle façon qu'il ne demeure sur les flancs du motif qu'une couche d'épaisseur submicronique,
- graver au moins la région centrale du motif, jusqu'à atteindre la couche active,
- implanter, en utilisant les restes du motif comme masque d'autoalignement, les régions d'accès de source et drain,
- sur ces régions implantées, déposer les métallisations de source et drain.

L'invention sera mieux comprise par la description qui suit du procédé en général, et de quelques exemples de réalisation, en liaison avec les figures jointes qui représentent :

- figures 1 à 4 : les principales étapes du procédé selon l'invention,
- figures 5 et 6 : vues en coupe et en plan, respectivement, d'une cellule de base d'un transistor à effet de champ, fabriqué selon le procédé de l'invention,
- figure 7 : vue en plan d'un transistor bi-grille cascode, selon l'invention,
- figures 8 et 9 : vues en coupe et en plan, respectivement, d'un transistor bi-grille, selon l'invention,
- figures 10 et 11 : vues en coupe et en plan, respectivement, d'un transistor en anneau , selon l'invention.

Afin de simplifier les explications et les figures, l'invention sera exposée en s'appuyant sur l'exemple d'un transistor à effet de champ, mais le procédé s'applique également aux transistors bipolaires : on sait que les géométries submicroniques sont l'un des problèmes des circuits à très haute intégration de type VLSI. Le procédé selon l'invention s'applique tant aux structures sur silicium qu'à celles sur GaAs ou autres matériaux du groupe III-V.

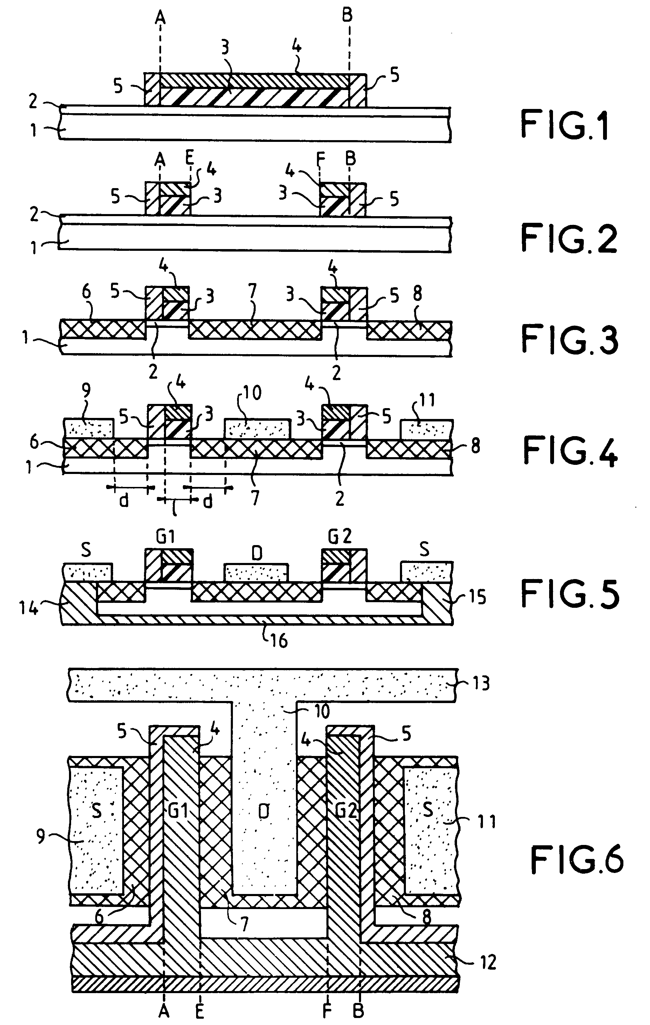

Dans ce même but de simplification, la figure 1 résume à elle seule plusieurs étapes préliminaires. On y voit la coupe d'une tranche de matériau semiconducteur, qui comporte un corps 1 et une couche active 2 en surface du corps 1. Il s'agit d'une tranche qui est presque en fin de processus de fabrication, et qui comprend un substrat, des couches de lissage, des couches de natures différentes, dopées ou non dopées, des caissons, etc... , qui me sont pas représentées sur les figures. Il ne reste à effectuer que les métallisations de grille, source et drain, sur la couche active 2, et l'implantation des caissons entre ces métallisations pour que le transistor ou le circuit intégré soit achevé. C'est sur un tel produit que s'applique le procédé selon l'invention.

La première étape consiste à déposer sur la totalité de la tranche une couche de diélectrique 3, épaisse de quelques micromètres, puis une couche 4 d'un premier métal, épaisse elle aussi. Par des moyens conventionnels, on grave ces deux couches 3 et 4 pour former, à la surface de la tranche, au moins un îlot dont deux bords au moins sont rectilignes et correspondent en A et B à l'emplacement de deux grilles hyperfines de transistors.

On dépose ensuite une couche fine - quelques fractions de micromètre - d'un second métal : cette couche d'épaisseur uniforme se dépose aussi sur les flancs de l'îlot 3 et 4. Ce second métal est de préférence réfractaire. Puis ce second métal est gravé de manière anisotrope de telle façon que les parties de la couche déposées sur la couche active 2 et sur la première couche métallique 4 sont supprimées, mais que demeure la partie qui en 5 entoure les flancs du motif 3 + 4.

C'est dans ce cadre 5 que seront réalisées au moins deux grilles hyperfines : l'avantage du procédé est que l'on sait réaliser et contrôler l'épaisseur de couches, depuis quelques nanomètres jusqu'à quelques micromètres, beaucoup plus facilement qu'on ne sait positionner un masque, pour fabriquer ces grilles hyperfines.

Le motif 3 + 4 a une dimension, selon la direction AB, qui se compte en microns, et la couche épaisse 4 du premier métal court-circuite les deux futures grilles 5.

Au moyen d'une machine de photolithographie permettant une précision d'alignement de 1 micron, on pratique une ouverture au centre du motif 3 + 4, entre les deux repères E et F qui sont compris entre A et B. La couche de métal 4 puis la couche de diélectrique 3 sont gravées, jusqu'à atteindre la couche active 2. Que la précision du masquage ne soit pas meilleure que 1 micron est sans importance puisque c'est l'épaisseur de la couche 5 de second métal qui définit la longueur de grille, inférieure à 1 micron.

En figure 3, des zones fortement dopées 6, 7 et 8 sont réalisées par implantation ionique, en utilisant les restes du motif 3 + 4 et les grilles 5 comme masque d'autoalignememt. Sous ce masque demeurent des zones de la couche active 2.

Enfin, en figure 4, les métalisations de source(s) et drain(s) sont déposées en 9, 10 et 11 sur les régions implantées 6, 7 et 8, respectivement. On verra ultérieurement, dans les exemples d'applications, comment se répartissent ces sources, grilles et drains, mais on peut constater sur la figure 4 que ce procédé fournit un transistor élémentaire qui est dissymétrique, bien que seulement des masques symétriques ont été utilisés. En effet, pour des questions de rendement de fabrication et de coût industriel, il est préférable d'utiliser des méthodes symétriques - masques, alignements, - pour réaliser des opérations microniques ou submicroniques. De même que le motif 3 + 4 a été gravé entre E et F au moyen d'un masque symétrique par rapport à A et B, de même les métallisations 9, 10 et 11 sont déposées de façon symétrique à une distance "d" des grilles. Mais cependant, chaque grille est constituée d'une partie métallique verticale 5, hyperfine, et d'une partie métallique horizontale 4, épaisse, qui s'appuie sur un socle de diélectrique 3, de longueur "l", de sorte que la grille 5 est séparée de la métallisation 9 d'une distance "d", et de la métallisation 10 d'une distance "l + d". La structure est dissymétrique et, pour avoir des tensions de claquage élevées côté drain, il est recommandé que la métallisation 10 soit le drain et la métallisation 9 soit la source, à l'échelle du transistor élémentaire.

Les figures 5 et 6 représentent, en coupe et en plan, une cellule de base d'un transistor à effet de champ. Cette cellule de base peut être considérée isolément, et former un transistor à une seule grille séparée en deux doigts G1 et G2, mais commandés par une seule tension. Si la cellule de base est répétée plusieurs fois de façon linéaire, on obtient un transistor de puissance interdigité. Les grilles 5 + 4 sont connectées à un bus métallique 12, qui est d'ailleurs réalisé en même temps qu'elles. Les drains 10 sont connectés à un bus métallique 13. Pour connecter les sources 9 et 11, qui sont les points chauds au cours du fonctionnement du transistor, le meilleur procédé consiste à sortir, à travers le corps 1, par des trous métallisés 14 et 15, connus sous le nom de "via holes", réunis à une métallisation 16 sur la face arrière du substrat.

La figure 6, et les suivantes, permettent de voir comment peut être gravé le motif initial 3 + 4 + 5. Ce motif a une géométrie qui est rectangulaire, et dont un premier et un second côtés rectilignes sont repérés en A et B. Pour transformer ce rectangle en deux grilles hyperfines G1 et G2, on l'a gravé, à l'intérieur des repères E et F, en supprimant un troisième côté du rectangle : les deux grilles G1 et G2 sont donc réunies par le quatrième côté, qui constitue le bus 12 de commande unique de toutes les grilles.

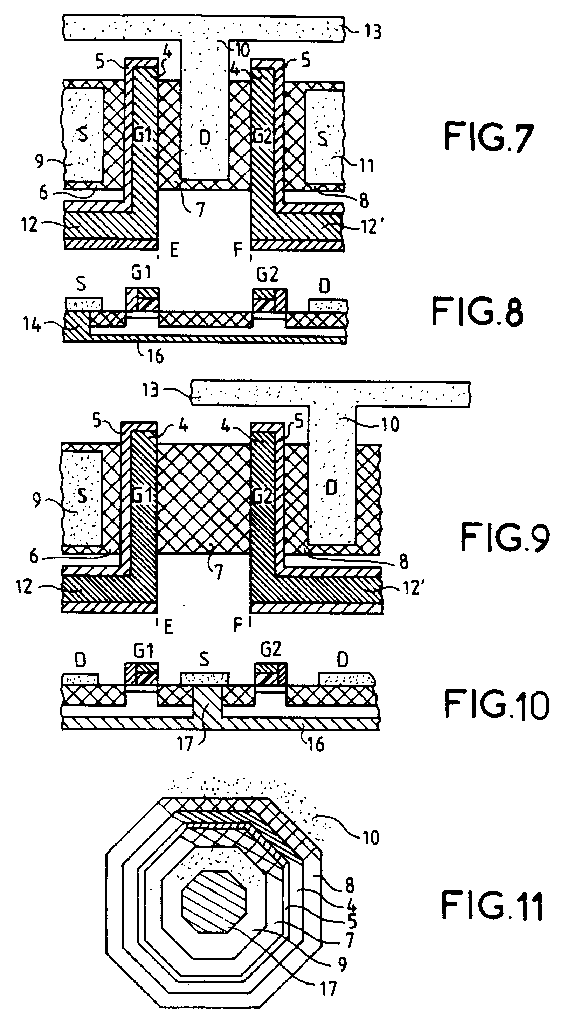

Cependant, si comme sur la figure 7, la gravure du motif 3 + 4 + 5 entre les repères E et F concerne les troisième et quatrième côtés du rectangle, les deux grilles G1 et G2 sont séparées. Le bus de commande est lui aussi séparé en deux conducteurs 12 et 12′, et la cellule représentée est un transistor bi-grille dit "cascode" commandé par deux tensions en 12 et 12′. Sa coupe est la même que celle de la figure 5, et les deux sources 9 et 11 sont réunies par des trous métallisés 14 et 15 à un bus 16.

Le même type de gravure du motif 3 + 4 + 5, mais avec des métallisations de source et drain différentes, permet de réaliser un transistor bi-grille, tel que représenté en figures 8 et 9. La métallisation 10 de drain n'est plus déposée entre les deux grilles G1 et G2, comme sur les figures précédentes, mais à l'emplacement de l'une des deux métallisations de source, 11 par exemple, sur une région implantée 8 située à l'extérieur des deux grilles. Seule la source 9 est réunie à un puits métallisé 14 et à une métallisation 16 sur la face arrière du substrat. Ce transistor bi-grille est commandé par deux tensions appliquées sur les métallisations 12 et 12′.

Les exemples décrits représentent des transistors ayant deux grilles. Cependant, on peut réaliser un motif diélectrique/métal 3 + 4 + 5 de dimensions assez grandes, selon les repères A et B, pour que, après gravure, la dimension entre les repères E et F soit suffisante pour y déposer deux métallisations côte à côte. Par exemple en figure 7, si on dépose deux drains, isolés entre eux, à la place de l'unique drain 10 représenté, on obtient deux transistors monogrille côte à côte.

De la même façon, le motif 3 + 4 + 5 représenté est un rectangle, parce que c'est un cas classique. Mais si ce motif a un configuration polygonale, avec plus de quatre côtés, et que ce polygone est gravé en son centre, on obtient un transistor élémentaire en anneau tel que représenté en figures 10 et 11. On sait que des associations de transistors en anneau sont une excellente solution pour obtenir de la puissance. Dans ce cas, ce sont les sources qui sont prises au centre de l'anneau, sur un trou métallisé 17 ou sur pont à air et les drains à l'extérieur de l'anneau.

Ce procédé présente les avantages suivants :
– réalisation d'une électrode de très faible dimension rendue possible par des moyens de lithographie traditionnels puisque cette dimension est définie par l'épaisseur du dépôt de métal 5 sur les flancs du motif 3 + 4 + 5.
– la résistance linéique de cette électrode peut être fortement réduite puisque l'armature supérieure 4 de l'électrode peut être de dimension quelconque.
– le couplage capacitif entre la partie supérieure 4 de cette électrode et la couche active 2 peut être faible par un choix judicieux du diélectrique 3 et de son épaisseur.
– enfin, cette structure appliquée à la réalisation d'un transistor, est, contrairement aux grilles en "T" classiques, dissymétrique et autorisé, couplée à un procédé d'autoalignement de grille par des zones implantées fortement dopées, à la fois la diminution de la résistance d'accès d'un côté de l'électrode (côté source) et l'augmentation de la tension de claquage de l'autre côté (côté drain), de manière indépendante.

**Revendications**

1. Procédé de réalisation de grilles submicroniques sur un dispositif semiconducteur comportant au moins une couche active (2) supportée par un substrat (1), ce procédé étant caractérisé en ce qu'il comporte les opérations suivantes :
   – sur la couche active (2), déposer une couche épaisse (3) de matériau diélectrique, puis une couche épaisse (4) de métal,
   – par masquage et gravure, former dans ces couches au moins un motif (3+4) polygonal dont au moins un premier et un second côtés (A, B) correspondent à la disposition d'au moins deux futures grilles (G1, G2),
   – par un procédé isotrope, déposer une couche de métal d'épaisseur submicronique, puis la graver par un procédé anisotrope, de telle façon qu'il ne demeure sur les flancs du motif (3 + 4) qu'une couche (5) d'épaisseur submicronique,
   – graver au moins la région centrale (E, F) du motif (3 + 4 + 5), jusqu'à atteindre la couche active (2),
   – implanter, en utilisant les restes du motif (3 + 4 + 5) comme masque d'autoalignement, les régions d'accès (6, 7, 8) de source et drain,
   – sur ces régions implantées (6, 7, 8), déposer les métallisations (9, 10, 11) de source et drain.

2. Procédé selon la revendication 1, caractérisé en ce que, en vue de réaliser une cellule de transistor en anneau, le motif (3 + 4 + 5) est un polygone à plus de 4 côtés, dont la gravure est limitée à la région centrale (E, F), dans laquelle une métallisation de source est connectée par un trou métallisé (17) ou par pont à air.

3. Procédé selon la revendication 1, caractérisé en ce que, en vue de réaliser une cellule de transistor bi-grille, le motif (3 + 4 + 5) est un rectangle et est en outre gravé sur un troisième côté, de sorte que les deux grilles (G1, G2), réunies par le quatrième côté (12) du motif (3 + 4 + 5) , sont commandées par une seule tension.

4. Procédé selon la revendication 1, caractérisé en ce que, en vue de réaliser une cellule de transistor bi-grille de type cascode, le motif (3 + 4 + 5) et un rectangle et est en outre gravé sur un troisième et quatrième côtés, opposés, de sorte que les deux grilles (G1, G2), séparées, sont commandées par deux tensions, la métallisation de drain (10) étant déposée sur la région implantée (7) située entre les deux grilles (G1, G2).

5. Procédé selon la revendication 1, caractérisé en que, en vue de réaliser une cellule de transistor bi-grille, le motif (3 + 4 + 5) est un rectangle et est en outre gravé sur un troisième et un quatrième côtés, opposés, de sorte que les deux grilles (G1, G2), séparées, sont commandées par deux tensions, les deux métallisations de source (9) et de drain (10) étant déposées sur les régions implantées (6, 8) situées à l'extérieur des deux grilles (G1, G2).

6. Procédé selon l'une quelconque des revendications 1 à 5, caractérisé en ce que le dispositif semiconducteur réalisé a une structure dissymétrique, la grille (5) étant plus proche d'une première électrode d'accès (S) que d'une deuxième électrode d'accès (D) en raison de la présence d'un reste de diélectrique (3).

FIG.1

FIG.2

FIG.3

FIG.4

FIG.5

FIG.6

FIG.7

FIG.8

FIG.9

FIG.10

FIG.11

**Office européen des brevets**

# RAPPORT DE RECHERCHE EUROPEENNE

Numero de la demande

EP    91 40 3345

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | PATENT ABSTRACTS OF JAPAN vol. 14, no. 2 (E-868)(3945) 8 Janvier 1990 & JP-A-1 251 669 ( NEC CORP ) 6 Octobre 1989 * abrégé; figures * | 1,6 | H01L21/28 H01L21/338 H01L29/812 |
| A | US-A-4 729 966 (Y. KOSHINO ET AL.) * figures 2,3 * | 1,2 | |
| A | IEEE MTT INT. MICROWAVE SYMPOSIUM DIGEST vol. 2, 27 Mai 1988, NEW YORK, US pages 569 - 572; A.E. GEISSBERGER ET AL.: 'A monolithic L-band limiting amplifier and dual-modulus prescaler GaAs integrated circuit.' * figure 1 * | 2 | |

DOMAINES TECHNIQUES RECHERCHES (Int. Cl.5)

H01L

Le présent rapport a été établi pour toutes les revendications

| Lieu de la recherche | Date d'achèvement de la recherche | Examinateur |
|---|---|---|
| LA HAYE | 21 AVRIL 1992 | GELEBART J.F.M. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant